# EUROPÄISCHE PATENTSCHRIFT

(11) **EP 1 831 055 B1**
(45) Veröffentlichungstag und Bekanntmachung des Hinweises auf die Patenterteilung: **07.04.2010**
(21) Anmeldenummer: 05776181.9
(22) Anmeldetag: 26.08.2005
(51) Int. Cl.: B60R 16/02, H05K 5/00

(54) **STEUERMODUL**
CONTROL MODULE
MODULE DE COMMANDE

(30) Priorität: 22.12.2004 DE 102004061818
(43) Veröffentlichungstag der Anmeldung: 12.09.2007
(73) Patentinhaber: ROBERT BOSCH GMBH, 70442 Stuttgart (DE)
(72) Erfinder: WETZEL, Gerhard, 70825 Korntal-Muenchingen (DE); SPRAFKE, Peter, 70469 Stuttgart (DE); GERHAEUSSER, Martin, 74389 Cleebronn (DE)
(86) Internationale Anmeldenummer: PCT/EP2005/054210
(87) Internationale Veröffentlichungsnummer: WO 2006/066983

(56) Entgegenhaltungen:
- DE-A1- 4 437 664
- DE-A1- 19 640 466
- US-A- 5 285 010
- US-A1- 2004 004 818
- US-B1- 6 570 773

## Beschreibung

### Stand der Technik

Die Erfindung betrifft ein Steuermodul mit den Merkmalen des Oberbegriffs des unabhängigen Anspruchs 1.

In der Kraflfahrzeugtechnik werden Steuermodule eingesetzt, die ein in das Kraftfahrzeug einbaubares Trägerteil aufweisen, an dem verschiedene, einer Komponente wie dem Getriebe oder dem Motor des Kraftfahrzeuges zugeordnete Bauteile angeordnet sind. So können beispielsweise Sensoren, Stecker, Stellglieder und auch ein mit einem elektronischen Schaltungsteil versehenes Steuergerätegehäuse an dem Trägerteil festgelegt werden. Bekannte Steuermodule zur Festlegung am Getriebe eines Kraftfahrzeuges weisen beispielsweise ein Trägerteil aus Kunststoff auf, das im Spritzgussverfahren hergestellt ist. Die elektrischen Verbindungen zwischen den verschiedenen elektrischen Bauteilen erfolgen über Stanzgitterteile, welche teilweise mit Kunststoff umspritzt sind. Das Steuergerät wird über Anschlussstifte mit den Stanzgitterteilen verbunden. Wird das Steuermodul im Getriebe angeordnet, muss das Steuergerät zuverlässig abgedichtet werden, um eine Beschädigung des Schaltungsteils durch eindringendes Getriebeöl zu vermeiden. Ein derartig abgedichtetes Steuergerät ist beispielsweise aus der DE 196 40 466 A1 bekannt.

Weiterhin ist aus der DE 44 37 664 A1 eine Steuermodul für eine Motorsteuerung bekannt, bei dem eine flexible Leiterfolie (FPC, Flexible Printed Circuit) zur Verbindung des Steuergerätes mit an dem Trägerteil angeordneten elektrischen Bauteilen verwandt wird. Flexible Leiterfolien haben den Vorteil, relativ leicht an die Einbausituation angepasst werden zu können. Flexible Leiterfolien weisen ein Trägerfolienband aus beispielsweise Polyimid auf, welche eine Leiterschicht beispielsweise aus Kupfer trägt. Die Leiterbahnen werden in einem Fotoprozess strukturiert und durch einen Ätzprozess ausgebildet. Die Leiterbahnen sind durch einen auf das Trägerfolienband aufgebrachten Schutzüberzug oder eine weitere Isolierfolie nach außen isoliert.

### Vorteile der Erfindung

Das erfindungsgemäße Steuermodul mit den kennzeichnenden Merkmalen des Anspruchs 1 ermöglicht es den Fertigungsaufwand und die Herstellungskosten des Steuermoduls zu reduzieren. Das Gehäuse des Steuergerätes ist vorteilhaft mit einem ersten Gehäuseteil an dem Trägerteil aufliegend angeordnet und das zweite Gehäuseteil ist innerhalb des Auflagebereichs an dem ersten Gehäuseteil angeordnet, was einen sehr kompakten Aufbau ermöglicht. Die Befestigung des Steuergeräts am Getriebe erfolgt vorzugsweise nur über das Trägerteil und das erste Gehäuseteil. Hierdurch ist sichergestellt, dass die als Klebeverbindung ausgeführte Dichtung zwischen zweitem Gehäuseteil und Leiterfolie außerhalb des Kraftflusses für die Befestigung liegt, so dass Verformungen , Schwingungen etc., die auf das Trägerteil einwirken, keinen schädigenden Einfluss auf die Dichtung haben.
Die Außenseite des ersten mit dem Schaltungsteil versehenen Gehäuseteils ist von dem Trägerteil abgewandt und kann als Kühlfläche beispielsweise auf ein Bauteil des Getriebes aufgesetzt werden. Die elektrische Kontaktierung zwischen den auf dem Trägerteil angeordneten Bauteilen und dem Steuergerät erfolgt über wenigstens eine flexible Leiterfolie, die an verschiedenen Auflagepunkten des Trägerteils festlegbar ist. Insbesondere ist es möglich, das Steuergerät im zusammengebauten Zustand an dem Trägerteil anzubringen und die Kontaktierung anschließend mittels der Leiterfolien zu bewerkstelligen. Aufgrund des modularen Aufbaus können alle an dem Trägerteil des Steuermoduls angeordneten Bauteile einschließlich des Steuergerätes vorteilhaft durch äußerlich in etwa gleichartig aufgebaute Bauteile mit anderen Spezifikationen ersetzt werden.

Vorteilhafte Ausführungsformen und Weiterbildungen der Erfindungen werden durch die in den abhängigen Ansprüchen beschriebenen Merkmale ermöglicht.

Eine besonders Platz sparende Bauweise wird ermöglicht, indem das zweite Gehäuseteil in eine Aussparung des Trägerteils hineinragt. Über Befestigungselemente, vorzugsweise Gewindebuchsen, im Tragteil wird das erste Gehäuseteil direkt zum Getriebe thermisch kontaktiert. Insgesamt wird hierdurch die Bauhöhe des Trägerteils stark reduziert und das als Kühlkörper dienende erste Gehäuseteil kann in optimaler Weise am Getriebe angeordnet werden.

Eine schüttel- und vibrationsfeste Montage der mit dem Steuergerät verbundenen Leiterfolie wird dadurch erreicht, dass diese an Vorsprüngen des Trägerteils angeordnet ist.

Besonders vorteilhaft ist es, wenn mehrere flexible Leiterfolien vorgesehen sind, wobei wenigstens zwei elektrische Bauteile des Trägerteils mittels jeweils einer separaten flexiblen Leiterfolie mit dem Schaltungsteil elektrisch verbunden sind. Wird nur eine einzige Leiterfolie zur Kontaktierung aller Bauteile verwandt, so ist es empfehlenswert, wenn diese das Schaltungsteil großflächig umgibt, was beispielsweise dadurch erreicht werden kann, dass die Leiterfolie an dem für das elektronische Schaltungsteil vorgesehenen Ort mit einer Ausstanzung versehen wird. Durch die Verwendung mehrerer Leiterfolienstreifen können die unterschiedlichen Bauteile mit dem Schaltungsteil gezielt elektrisch verbunden werden, ohne Stücke aus der relativ teuren Leiterfolie herausstanzen zu müssen.

Es ist aber auch möglich, die wenigstens eine Leiterfolie außerhalb des Gehäuseinnenraums mit elektrischen Anschlusselementen zu verbinden, die zwischen dem ersten Gehäuseteil und dem zweiten Gehäuseteil in den Gehäuseinnenraum geführt und dort wenigstens mittelbar mit dem Schaltungsteil verbunden sind. In diesem Fall kann die Leiterfolie nach Herstellung des dichten Steuergerätes mit den Anschlusselementen verbunden werden. Die Anschlusselemente können durch die Leiterbahnen einer weiteren Leiterfolie gebildet werden.

Bei der Verwendung mehrerer Leiterfoliestreifen ergeben sich durch die Leiterfolienstreifen unterschiedliche Klebespalthöhen. Daraus resultieren hohe Anforderungen an die Dichtfunktion. Besonders vorteilhaft ist es daher, die Leiterfolie im Bereich des Schaltungsteils und der diesen Bereich umgebenden Dichtung als ein Stück auszuführen, um eine konstant Klebespalthöhe zu erreichen, und die Leiterfolienstreifen außerhalb des Gehäuseinnenraums zu kontaktieren. Hierdurch ergibt sich auch die Möglichkeit, das Steuergerät als kleine in der Montage einfach handhabbare Baugruppe auszubilden und mit Bauteilen vorkonfektionierte flexible Leiterfolienstreifen an das Steuergerät anzuschließen. Durch Austausch der Leiterfolienstreifen sind unterschiedliche Varianten ebenfalls einfach darstellbar.

Vorteilhaft kann die wenigstens eine flexible Leiterfolie zwischen dem ersten Gehäuseteil und dem zweiten Gehäuseteil in den Gehäuseinnenraum des Steuergerätes geführt sein und dort wenigstens mittelbar mit dem Schaltungsteil elektrisch verbunden werden.

### Zeichnungen

Ausführungsbeispiele der Erfindung sind in den Zeichnungen dargestellt und werden in der nachfolgenden Beschreibung erläutert. Es zeigt
Fig. 1 einen Querschnitt durch ein erstes Ausführungsbeispiel eines erfindungsgemäßen Steuermoduls,
Fig. 2a einen Querschnitt durch das Ausführungsbeispiel eines erfindungsgemäßen Steuermoduls in Fig. 3 entlang der Linie A-A,
Fig. 2b einen Querschnitt durch das Ausführungsbeispiel eines erfindungsgemäßen Steuermoduls in Fig. 3 entlang der Linie B-B,
Fig. 3 einen perspektivischen Ausschnitt aus dem ersten Ausführungsbeispiel eines erfindungsgemäßen Steuermoduls,
Fig. 4 einen perspektivischen Ausschnitt aus einem zweiten Ausführungsbeispiel eines erfindungsgemäßen Steuermoduls,
Fig. 5 einen perspektivischen Ausschnitt aus einem dritten Ausführungsbeispiel eines erfindungsgemäßen Steuermoduls,
Fig. 6 einen perspektivischen Ausschnitt aus einem Steuermodul.

### Beschreibung der Ausführungsbeispiele

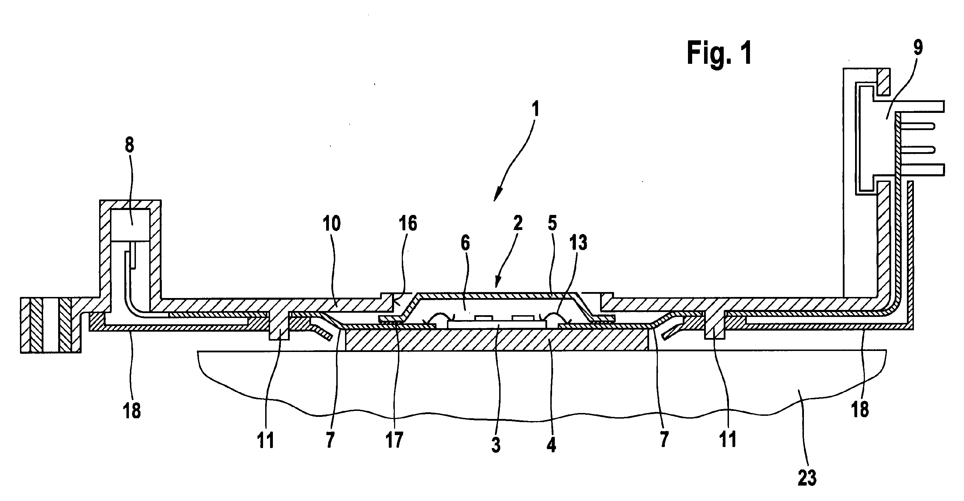

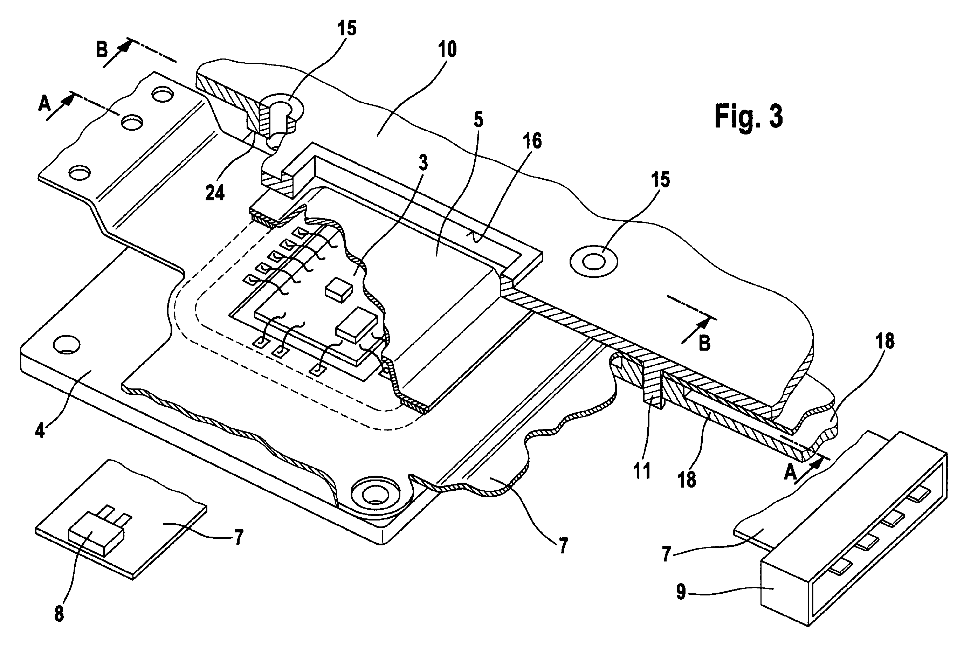

Fig. 1 und Fig. 3 zeigen ein erstes Ausführungsbeispiel eines erfindungsgemäßen Steuermoduls. Das Steuermodul 1 umfasst ein Trägerteil 10 aus Metall oder Kunststoff, welches am Getriebe eines Kraftfahrzeuges festlegbar ist. Das Trägerteil ist beispielsweise plattenförmig mit davon abstehenden Stegen und Vorsprüngen ausgebildet. An dem Trägerteil sind elektrische Bauteile, wie beispielsweise Steckerteile 9, Sensoren 8, nicht dargestellte Hydraulikventile zur Ansteuerung von Stellgliedern eines Getriebes und ein Getriebesteuergerät 2 angeordnet.

Das Steuergerät 2 weist ein erstes Gehäuseteil 4 auf, welches vorzugsweise als metallisches Bodenteil aus beispielsweise Aluminium ausgebildet ist, und ein zweites Gehäuseteil 5, welches vorzugsweise als metallisches Deckelteil aus beispielsweise Aluminium ausgebildet ist. Die Gehäuseteile können aber auch aus einem anderen Material gefertigt werden. Insbesondere das zweite Gehäuseteil 5 kann als Kunststoffteil gefertigt werden. Das erste Gehäuseteil 4 und das zweite Gehäuseteil 5 bergen einen Gehäuseinnenraum 6. Innerhalb des Gehäuseinnenraums 6 ist an dem ersten Gehäuseteil 4 ein elektronisches Schaltungsteil 3, beispielsweise eine auf einem keramischen Trägersubstrat angeordnete Hybridschaltung aufgebracht. Das Schaltungsteils 3 kann beispielsweise auf das erste Gehäuseteil 4 aufgeklebt oder aufgelötet werden und ist über Bonddrähte 13 mit einer flexiblen Leiterfolie 7 verbunden, welche mehrere elektrische Leiterbahnen aufweist. Das Schaltungsteil 3 kann mit einem Gel abgedeckt sein. Die Leiterfolie 7 ist mit einer beispielsweise rechteckförmigen Ausnehmung versehen, innerhalb der das Schaltungsteil 3 angeordnet ist. Die Leiterfolie 7 ist zwischen dem ersten Gehäuseteil 4 und dem zweiten Gehäuseteil 5 aus dem Gehäuseinnenraum 6 dicht herausgeführt und kann auf das erste Gehäuseteil 5 beispielsweise dicht aufgeklebt werden. Zur Abdichtung des Steuergerätes 2 ist im Auflagebereich von erstem Gehäuseteil 4 und zweitem Gehäuseteil 5 eine Dichtung 17 vorgesehen. Die Dichtung 17 kann aus einer beidseitig klebenden Klebefolie aus beispielsweise einem Acrylkleber oder aber aus einem flüssigen Klebstoff bestehen. Dieser kann auf die Leiterfolie 7 oder das zweite Gehäuseteil 5 durch Drucken oder Dispensen aufgebracht werden.. Die Dichtung 17 kann auch als Elastomerdichtung ausgeführt werden. Hierbei ist in bekannter Weise eine zusätzliche mechanische Befestigung des zweites Gehäuseteils an das erste Gehäuseteil erforderlich, um die notwendige Vorspannung für den Elastomer aufzubringen und die Fixierung des zweiten Gehäuseteils 5 zu erreichen.

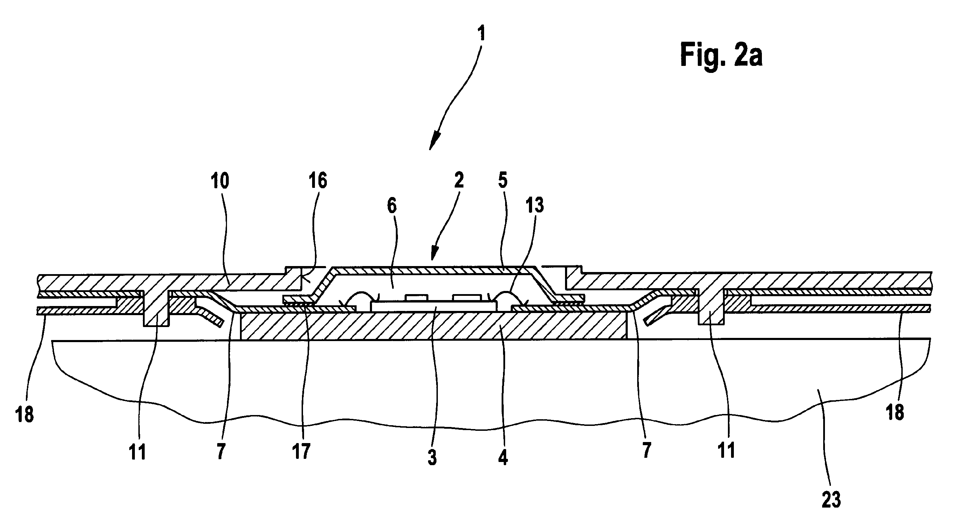

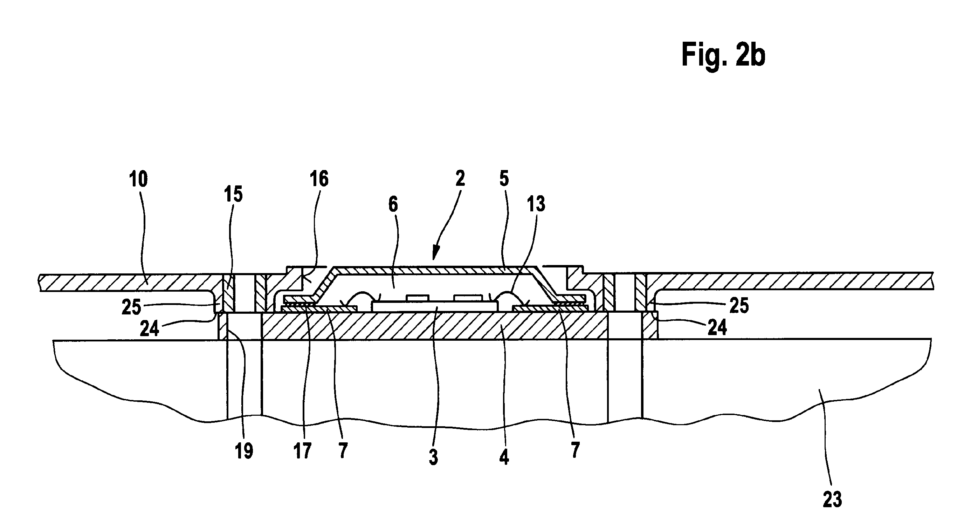

Zur Aufnahme des Steuergerätes weist der plattenförmige Zentralabschnitt des Trägerteils 10 eine durchgehende, beispielsweise rechteckförmige Aussparung 16 auf. Wie in Fig. 2b und Fig. 3 dargestellt ist, ist das Steuergerät 2 mit dem ersten Gehäuseteil 4 aufliegend an dem Trägerteil 10 angeordnet, wobei die dem Trägerteil zugewandte Seite des ersten Gehäuseteils 4 an einem Auflagebereich 24 des Trägerteils zur Anlage gelangt. Der Auflagebereich 24 des Trägerteils 10 kann beispielsweise durch zwei erhabene Fläche an Vorsprüngen 25 gebildet werden, die an zwei sich gegenüberliegenden Seiten der Aussparung 16 ausgebildet sind. Der Auflagebereich 24 kann auch durch eine umlaufende erhabene Fläche oder durch mehrerer Vorsprünge ausgebildet werden. Wie in Fig. 2b gut zu erkennen ist, wird durch die von der dem ersten Gehäuseteil zugewandten Seite des Trägerteils 10 vorstehenden Vorsprünge 25 erreicht, dass zwischen der dem Trägerteil zugewandten Seite des ersten Gehäuseteils 4 und der dem ersten Gehäuseteil 10 zugewandten Seite des Trägerteils ein Abstand besteht, der Platz für die Montage des zweiten Gehäuseteils 5 bietet, das innerhalb des Auflagebereiches 24, also zwischen den beiden Vorsprüngen 25, an dem Trägerteil angeordnet ist. In der Umgebung der Aussparung 16 sind im Auflagebereich 24 Befestigungselemente 15 in das Trägerteil 10 integriert, die es erlauben, das Trägerteil 10 und das erste Gehäuseteil 4 an einem wärmeleitenden Gehäuseteil 23 des Getriebes zu befestigen, beispielsweise dadurch, dass Schrauben (nicht dargestellt) durch Bohrungen 19 im ersten Gehäuseteil 4 in die Befestigungselemente 15 des Trägerteils 10 eingeschraubt werden. Wie in Fig. 2a und Fig. 2b dargestellt, ist das Steuergerät 2 über die Befestigungselemente 15 mit dem Trägerteil 10 verbunden, so dass auf das zweite Gehäuseteil 5 keine Haltekräfte einwirken. Die aus dem Steuergerät herausragende Leiterfolie 7 ist an verschiedenen Vorsprüngen 11 des Trägerteils 10 positioniert und durch eine auf das Trägerteil aufgebrachte Abdeckung 18 gesichert. Die Abdeckung 18 kann beispielsweise durch ein plattenförmiges Teil aus Kunststoff oder Metall gebildet werden, dass im Wesentlichen parallel zum Trägerteil verlaufend an diesem befestigbar ist. Hierzu kann die Abdeckung 18 beispielsweise auf die Vorsprünge 11 des Trägerteils aufgesteckt werden. Die von dem Steuergerät 2 abgewandten Enden der Leiterfolie 7 sind mit dem Steckerteil 9, Sensoren 8 und gegebenenfalls weiteren an dem Trägerteil 10 angeordneten Bauteilen elektrisch verbunden, was beispielsweise durch Schweißen oder Löten geschehen kann. Wie in Fig. 1, 2a und 2b weiterhin zu erkennen ist, ist die von dem zweiten Gehäuseteil 5 abgewandte Außenseite des ersten Gehäuseteils 4 an der Unterseite des Trägerteils 10 frei zugänglich und kann beispielsweise direkt ins Getriebeöl eingetaucht werden oder auf ein wärmeableitendes Gehäuseteil des Getriebes aufgesetzt werden, was besonders vorteilhaft ist, da das erste Gehäuseteil 4 als Kühlkörper für das darauf aufgeklebte elektronische Schaltungsteil 3 vorgesehen ist.

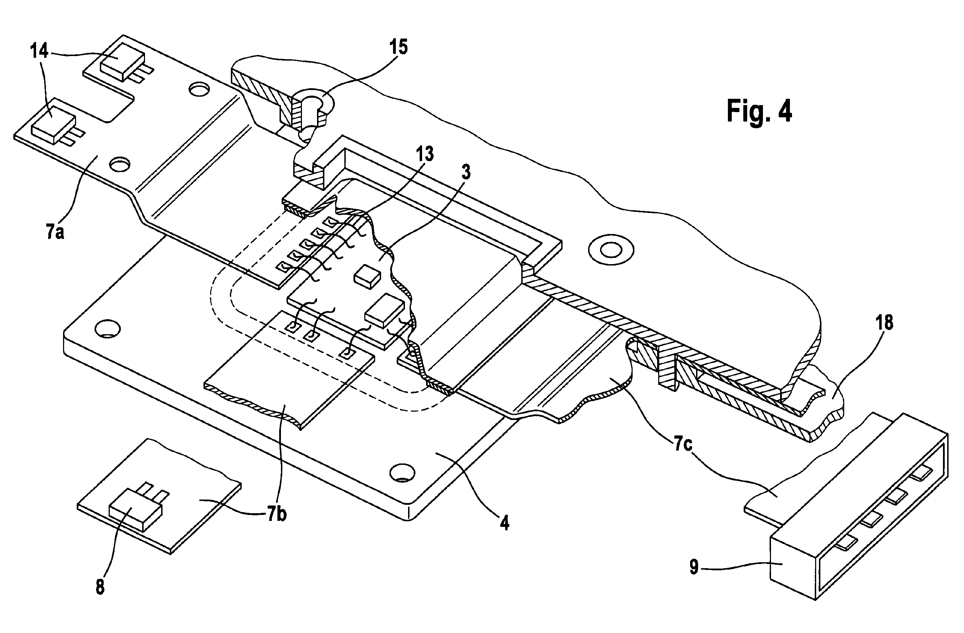

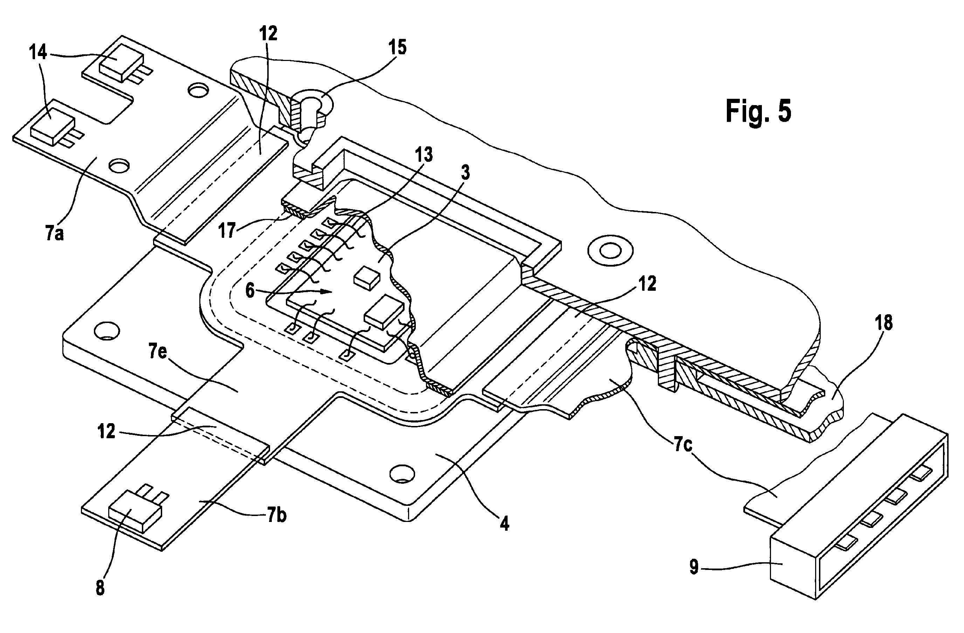

In Fig. 3 ist die oben beschriebene Ausführungsform perspektivisch dargestellt. Fig. 4 zeigt ein weiteres Ausführungsbeispiel der Erfindung, welches sich von dem in Fig. 3 dargestellten Ausführungsbeispiel dadurch unterscheidet, dass nicht nur eine flexible Leiterfolie zur elektrischen Verbindung des Schaltungsteils 3 mit den Bauteilen des Trägerteils 10 vorgesehen ist. Das Schaltungsteil 3 ist über mehrere streifenförmige Leiterfolien 7a, 7b, 7c mit Bauteilen 8, 9 und 14 verbunden. Eine weitere Ausführungsform zeigt Fig. 5. Auf dem ersten Gehäuseteil 4 ist im Bereich des Schaltungsteils 3 und der diesen Bereich umgebenden Dichtung 17 eine geschlossene Leiterfolie 7e dicht aufgeklebt und über Bonddrähte 13 mit dem Schaltungsteil 3 kontaktiert. Die Leiterbahnen dieser Leiterfolie 7e bilden aus dem Gehäuse herausragende elektrische Anschlusselemente für den Anschluss weiterer Leiterfolien 7a, 7b, 7c. Außerhalb des Gehäuseinnenraumes 6 ist die Leiterfolie 7e an den Verbindungsstellen 12 mit den Leiterfolienstreifen 7a, 7b, 7c verbunden, deren andere Enden mit den Bauteilen 8, 9 und 14 verbunden sind. Einzelne Bauteile 14 können auch direkt auf den Leiterfolien angeordnet werden, hierbei kann ein Leiterfolienstreifen auch mehrere Bauelemente 14 kontaktieren. Bei dieser Vorgehensweise kann das Steuergerät 2 unabhängig von den Leiterfolien 7a, 7b, 7c an dem Trägerteil 10 festgelegt werden, wobei die Verbindungsstellen 12 nach der Montage des Steuergerätes und der Leiterfolien, beispielsweise durch Kleben oder Schweißen hergestellt werden können.

Es ist natürlich auch möglich, Leiterfolienstreifen für die Kontaktierung bestimmter Bauelemente durchgehend unter Verzicht auf die Verbindungsstellen 12 auszubilden und für andere Bauelemente separate Leiterfolienstreifen mit Verbindungsstelle 12 zu verwenden. Es ergibt sich in diesem Fall eine Kombination der in Fig. 3 und Fig. 5 gezeigten Ausführungsformen. Da bei den Ausführungsbeispielen aus Fig. 4 und Fig. 5 mehrere kleine Leiterfolienstreifen verwandt werden, lässt sich der Verschnitt minimieren. Heraus ergibt sich eine deutliche Kostenersparnis, die umso ausgeprägter ist, je weiter die zu kontaktierenden Sensoren und Stecker vom Schaltungsteil 2 entfernt sind. Zusätzlich ergibt sich die Möglichkeit, die Bauelemente 8, 14 oder auch Stecker 9 an einem Leiterfolienstreifen komplett vorzukonfektionieren und so einen besonders günstigen Fertigungsablauf zu erreichen. Des weiteren kann durch Austausch eines Leiterstreifens durch einen mit anderer Geometrie ein kostengünstiges, einfaches Variantenmanagement dargestellt werden. Bei der Herstellung des Steuergeräts nach Fig. 5 kann zuerst die Leiterfolie 7e auf das erste Gehäuseteil geklebt werden. Dann wird die Schaltung 3 eingeklebt und zu der Leiterfolie 7e mittels Bonds 13 kontaktiert Anschießend wird das zweite Gehäuseteil 5 mit dem ersten Gehäuseteil 4 dicht verklebt. Hierzu wird eine beidseitig klebende Folie mit Hilfe geeigneter Zentrierbohrungen oder Stifte zunächst auf das erste Gehäuseteil 4 und die Leiterfolienstreifen 7e aufgetragen. Anschließend wird das zweite Gehäuseteil 5 aufgesetzt. Die Anpresskraft sollte so bemessen sein, dass zwischen den beiden Gehäuseteilen ein dichter Verschluss entsteht, aus dem die Leiterfolienstreifen 7e herausgeführt sind. Hierdurch ergibt sich eine baulich kleine und dadurch in der Montage einfach handhabbare Einheit, die anschließend über die Verbindungsbereiche 12 an die Leiterfolienstreifen 7a, 7b, 7c angeschlossen wird und letztlich mit dem Tragteil 10 komplettiert wird.

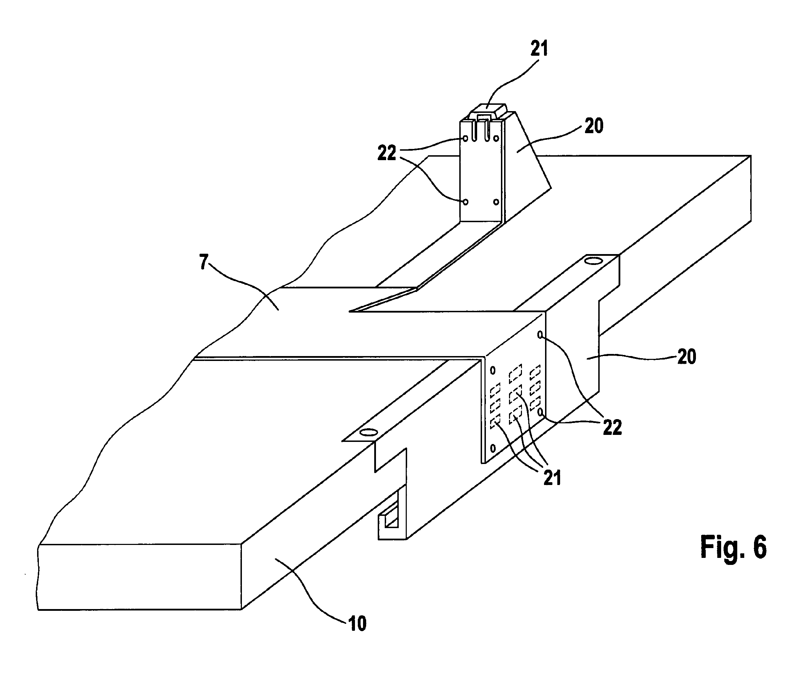

Weiterhin ist es möglich, als ASIC (Application-Specific Integrated Circuit) ausgebildete einzelne Sensorelemente, Standard oder andere Bauteile an dem Trägerteil 10 des Steuermoduls anzuordnen. Hierbei kann es sich beispielsweise um Drehzahlsensoren handeln. Eine vorteilhafte Methode zur Kontaktierung der flexiblen Leiterfolie 7 mit den ASIC-Bauteilen ist in Fig. 6 gezeigt. Die ASIC-Bauteile 21 sind in Aufnahmeteile 20 eingelegt, die an dem Trägerteil 10 festgelegt sind. Die Aufnahmeteile 20 können auch einstückig mit dem Trägerteil 10 ausgebildet sein. Die flexible Leiterfolie 7 wird über die Anschlussstifte der ASIC-Bauteile 21 gelegt und mit diesen durch Schweißen, Löten oder Klemmverbindungen kontaktiert. Zur Festlegung der Lage der Leiterfolie dienen Positionierstifte 22, die an den Aufnahmeteilen 20 angeordnet sind.

### Bezugszeichenliste

- 1: Steuermodul
- 2: Steuergerät
- 3: Elektronisches Schaltungsteil
- 4: Erstes Gehäuseteil
- 5: Zweites Gehäuseteil
- 6: Gehäuseinnenraum
- 7: Flexible Leiterfolie
- 7a, 7b, 7c, 7e: Leiterfolien
- 8: Sensor
- 9: Steckerteil
- 10: Trägerteil
- 11: Vorsprung
- 12: Verbindungsbereich
- 13: Bondrähte
- 14: Bauteil
- 15: Befestigungselemente
- 16: Aussparung
- 17: Dichtung
- 18: Abdeckung
- 19: Bohrungen
- 20: Aufnahmeteile
- 21: ASIC-Bauteile
- 22: Positionierstifte
- 23: wärmeleitendes Gehäuseteil
- 24: Auflagebereich
- 25: Vorsprung

## Patentansprüche

1. Steuermodul insbesondere für ein Getriebe eines Kraftfahrzeuges
- mit einem Trägerteil (10),
- einem an einem Trägerteil (10) angeordneten Steuergerät (2), welches ein erstes Gehäuseteil (4) und ein zweites Gehäuseteil (5) und einen zwischen dem ersten Gehäuseteil und dem zweiten Gehäuseteil angeordneten Gehäuseinnenraum (6) aufweist, in dem ein an dem ersten Gehäuseteil (4) befestigtes elektronisches Schaltungsteil (3) angeordnet ist,
- und mit wenigstens einer flexiblen Leiterfolie (7, 7a, 7b, 7c,7e) zur elektrischen Verbindung des Schaltungsteils (3) mit außerhalb des Gehäuseinnenraums (6) angeordneten elektrischen Bauteilen (8, 9, 14),
**dadurch gekennzeichnet,**
**dass** das Steuergerät (2) mit dem ersten Gehäuseteil (4) an einem Auflagebereich (24) des Trägerteil (10) aufliegend angeordnet ist und das zweite Gehäuseteil (5) innerhalb des Auflagebereichs an dem ersten Gehäuseteil (4) angeordnet ist.

2. Steuermodul nach Anspruch 1, **dadurch gekennzeichnet, dass** das Steuermodul mittels des Trägerteils (10) und/oder des ersten Gehäuseteils (4) am Getriebe des Kraftfahrzeuges festlegbar ist.

3. Steuermodul nach Anspruch 1, **dadurch gekennzeichnet, dass** die wenigstens eine flexible Leiterfolie an Vorsprüngen des Trägerteils angeordnet ist.

4. Steuermodul nach Anspruch 1, **dadurch gekennzeichnet, dass** mehrere flexible Leiterfolien (7a, 7b, 7c) vorgesehen sind, wobei wenigstens zwei unterschiedliche elektrische Bauteile (8, 9, 14) mittels jeweils einer flexiblen Leiterfolie mit dem Schaltungsteil (3) elektrisch verbunden sind.

5. Steuermodul nach einem der Ansprüche 1 bis 4, **dadurch gekennzeichnet, dass** die wenigstens eine flexible Leiterfolie (7, 7e) zwischen dem ersten Gehäuseteil (4) und dem zweiten Gehäuseteil (5) in den Gehäuseinnenraum (6) geführt ist und dort wenigstens mittelbar mit dem Schaltungsteil (3) elektrisch verbunden ist.

6. Steuermodul nach Anspruch 1 bis 4, **dadurch gekennzeichnet, dass** die wenigstens eine Leiterfolie (7a, 7b, 7c) außerhalb des Gehäuseinnenraums (6) mit elektrischen Anschlusselementen verbunden ist, die zwischen dem ersten Gehäuseteil (4) und dem zweiten Gehäuseteil (5) in den Gehäuseinnenraum (6) geführt sind und dort wenigstens mittelbar mit dem Schaltungsteil (3) verbunden sind.

7. Steuermodul nach Anspruch 6, **dadurch gekennzeichnet, dass** die Anschlusselemente durch die Leiterbahnen wenigstens einer weiteren flexiblen Leiterfolie (7e) gebildet werden.

8. Steuermodul nach Anspruch 1 bis 7, **dadurch gekennzeichnet, dass** auf dem ersten Gehäuseteil (4) eine das Schaltungsteil (3) umgebende, großflächige, flexible Leiterfolie (7e) dicht aufgeklebt und über Bonddrähte (13) mit dem Schaltungsteil (3) kontaktiert ist und zumindest einige weitere flexible Leiterfolienstreifen (7a, 7b, 7c) außerhalb des Gehäuseinnenraumes (6) an Verbindungsstellen (12) mit der großflächigen flexiblen Leiterfolie (7e) verbunden sind.

9. Steuermodul nach Anspruch 8, **dadurch gekennzeichnet, dass** die großflächige flexible Leiterfolie (7e) zwischen dem ersten Gehäuseteil (4) und dem zweiten Gehäuseteil (5) unter Zwischenlage einer Dichtung (17) aus dem Gehäuseinnenraum (6) abgedichtet herausgeführt ist.

10. Steuermodul nach einem der vorstehenden Ansprüche, **dadurch gekennzeichnet, dass** wenigstens ein elektronisches Bauteil (14) auf einen Teilabschnitt der flexiblen Leiterfolie (7a) aufgebracht ist.

## Claims

1. Control module, in particular for a gearbox of a motor vehicle,
- having a carrier part (10),
- a controller (2) which is arranged on a carrier part (10) and has a first housing part (4) and a second housing part (5) and a housing interior (6) which is arranged between the first housing part and the second housing part and in which an electronic circuit part (3) which is attached to the first housing part (4) is arranged,
- and having at least one flexible conductor foil (7, 7a, 7b, 7c, 7e) for electrically connecting the circuit part (3) to electrical components (8, 9, 14) which are arranged outside the housing interior (6),
**characterized**
**in that** the controller (2) is arranged such that it bears against a bearing region (24) of the carrier part (10) by way of the first housing part (4) and the second housing part (5) is arranged on the first housing part (4) within the bearing region.

2. Control module according to Claim 1, **characterized in that** the control module can be fixed to the gearbox of the motor vehicle by means of the carrier part (10) and/or the first housing part (4).

3. Control module according to Claim 1, **characterized in that** the at least one flexible conductor foil is arranged on projections of the carrier part.

4. Control module according to Claim 1, **characterized in that** a plurality of flexible conductor foils (7a, 7b, 7c) are provided, with at least two different electrical components (8, 9, 14) being electrically connected to the circuit part (3) by means of a flexible conductor foil in each case.

5. Control module according to one of Claims 1 to 4, **characterized in that** the at least one flexible conductor foil (7, 7e) is routed into the housing interior (6) between the first housing part (4) and the second housing part (5), and is electrically connected, at least indirectly, to the circuit part (3) in the said housing interior.

6. Control module according to Claims 1 to 4, **characterized in that** the at least one conductor foil (7a, 7b, 7c) is connected to electrical connection elements outside the housing interior (6), the said electrical connection elements being routed into the housing interior (6) between the first housing part (4) and the second housing part (5), and being connected, at least indirectly, to the circuit part (3) in the said housing interior.

7. Control module according to Claim 6, **characterized in that** the connection elements are formed by the conductor tracks of at least one further flexible conductor foil (7e).

8. Control module according to Claims 1 to 7, **characterized in that** a flexible conductor foil (7e) of large surface area which surrounds the circuit part (3) is adhesively bonded in a sealed manner on the first housing part (4) and is contact-connected to the circuit part (3) by means of bonding wires (13), and at least some further flexible conductor foil strips (7a, 7b, 7c) are connected to the flexible conductor foil (7e) of large surface area outside the housing interior (6) at connection points (12).

9. Control module according to Claim 8, **characterized in that** the flexible conductor foil (7e) of large surface area is routed, in a sealed off manner, out of the housing interior (6) between the first housing part (4) and the second housing part (5), with the interposition of a seal (17).

10. Control module according to one of the preceding claims, **characterized in that** at least one electronic component (14) is mounted on a subsection of the flexible conductor foil (7a).

## Revendications

1. Module de commande, en particulier pour une transmission d'un véhicule automobile, comprenant :
- une partie de support (10),
- un appareil de commande (2) disposé sur une partie de support (10), qui présente une première partie de boîtier (4) et une deuxième partie de boîtier (5) et un espace interne de boîtier (6) disposé entre la première partie de boîtier et la deuxième partie de boîtier, dans lequel est disposée une partie de commutation électronique (3) fixée à la première partie de boîtier (4),
- et au moins une feuille conductrice flexible (7, 7a, 7b, 7c, 7e) pour la connexion électrique de la partie de commutation (3) à des composants électriques (8, 9, 14) disposés à l'extérieur de l'espace interne de boîtier (6),
**caractérisé en ce que**
l'appareil de commande (2) est disposé de manière à s'appliquer avec la première partie de boîtier (4) sur une région d'appui (24) de la partie de support (10) et la deuxième partie de boîtier (5) est disposée à l'intérieur de la région d'appui sur la première partie de boîtier (4).

2. Module de commande selon la revendication 1, **caractérisé en ce que** le module de commande peut être fixé au moyen de la partie de support (10) et/ou de la première partie de boîtier (4) à la transmission du véhicule automobile.

3. Module de commande selon la revendication 1, **caractérisé en ce que** l'au moins une feuille conductrice flexible est disposée sur des saillies de la partie de support.

4. Module de commande selon la revendication 1, **caractérisé en ce que** plusieurs feuilles conductrices flexibles (7a, 7b, 7c) sont prévues, au moins deux composants électriques différents (8, 9, 14) étant connectés électriquement à la partie de commutation (3) à chaque fois au moyen d'une feuille conductrice flexible.

5. Module de commande selon l'une quelconque des revendications 1 à 4, **caractérisé en ce que** l'au moins une feuille conductrice flexible (7, 7e) est guidée entre la première partie de boîtier (4) et la deuxième partie de boîtier (5) dans l'espace interne de boîtier (6) et y est connectée électriquement au moins de manière indirecte à la partie de commutation (3).

6. Module de commande selon les revendications 1 à 4, **caractérisé en ce que** l'au moins une feuille conductrice (7a, 7b, 7c) est connectée à l'extérieur de l'espace interne de boîtier (6) à des éléments de raccordement électriques, qui sont guidés entre la première partie de boîtier (4) et la deuxième partie de boîtier (5) dans l'espace interne de boîtier (6) et qui y sont connectés de manière au moins indirecte à la partie de commutation (3).

7. Module de commande selon la revendication 6, **caractérisé en ce que** les éléments de raccordement sont formés par les pistes conductrices d'au moins une autre feuille conductrice flexible (7e).

8. Module de commande selon les revendications 1 à 7, **caractérisé en ce que** sur la première partie de boîtier (4) est collée, de manière hermétique, une feuille conductrice flexible (7e) de grande surface entourant la partie de commutation (3), qui est en contact par le biais de fils de liaison (13) avec la partie de commutation (3), et au moins quelques autres bandes de feuille conductrice flexibles (7a, 7b, 7c) sont connectées en dehors de l'espace interne de boîtier (6) au niveau de points de connexion (12) à la feuille conductrice flexible de grande surface (7e).

9. Module de commande selon la revendication 8, **caractérisé en ce que** la feuille conductrice flexible de grande surface (7e) est guidée entre la première partie de boîtier (4) et la deuxième partie de boîtier (5) hors de l'espace interne de boîtier (6) de manière hermétique en interposant un joint d'étanchéité (17).

10. Module de commande selon l'une quelconque des revendications précédentes, **caractérisé en ce qu'**au moins un composant électronique (14) est monté sur une portion partielle de la feuille conductrice flexible (7a).
